# EUROPÄISCHE PATENTSCHRIFT

(11) **EP 1 257 021 B1**
(45) Veröffentlichungstag und Bekanntmachung des Hinweises auf die Patenterteilung: **04.10.2006**
(21) Anmeldenummer: 02009623.6
(22) Anmeldetag: 27.04.2002
(51) Int. Cl.: H01R 43/01, H05K 1/11

(54) **Einrichtung zur Konfektionierung von flexiblen Leiterplatten**
Device for building flexible printed circuits
Dispositif pour la fabrication des plaques à circuits flexibles

(30) Priorität: 07.05.2001 EP 01810443
(43) Veröffentlichungstag der Anmeldung: 13.11.2002
(73) Patentinhaber: Komax Holding AG, 6036 Dierikon (CH)
(72) Erfinder: Grätzer, Walter, 8840 Einsiedeln (CH)
(74) Vertreter: Gaussmann, Andreas

(56) Entgegenhaltungen:
- EP-A- 1 009 077
- WO-A-90/07804
- US-A- 4 043 017
- US-A- 4 110 896

## Beschreibung

Die Erfindung betrifft eine Einrichtung zur Konfektionierung einer flexiblen Leiterplatte mit mindestens einem mindestens ein Leiterende umfassenden Segment, wobei das Segment Teil der flexiblen Leiterplatte ist und zur Bearbeitung aufrichtbar ist.

Flexible Leiterplatten (Flexible Printed Circuit FPC), bestehen aus mindestens einer Schicht elektrisch isolierendem Material und aus mindestens einer Schicht elektrisch leitendem Material. Als elektrisch leitendes Material wird üblicherweise Kupfer verwendet, das auf einer Basisfolie angebracht ist. Die Herstellung der Leiterbahnen erfolgt üblicherweise mittels eines chemischen Prozesses. Die für die Leiterbahnen benötigte Kupferfläche wird kaschiert. Anschliessend wird die ungeschützte Kupferfläche beispielsweise mittels Ätzverfahren entfernt. Mit dieser Fertigungstechnik sind komplexe Leiterbahnanordnungen und minimale Leiterbahnabstände machbar. Die Leiterbahnen werden beispielsweise mittels Löttechnik oder mittels Crimptechnik angeschlossen. Bei einer Lötverbindung verbindet ein Lot mit tiefem Schmelzpunkt unter Wärmeeinwirkung den Kupfer der Leiterbahn mit beipielsweise einem Kontaktbein eines Steckers. Bei einer Crimpverbindung werden die Kontakte mechanisch mit der Leiterbahn verbunden.

Am Ende mindestens einer Leiterbahn wird die flexible Leiterplatte seitlich und stirnseitig der Leiterbahn(en) eingeschnitten bzw. geschlitzt. (Der lose Teil mit den Leiterbahnenden wird Segment genannt). Am nun frei beweglichen Leiterbahnende wird der Kontakt mittels Crimpverfahren mit der Leiterbahn verbunden. Dabei durchstossen Krallen des Kontaktes (piercing process) die flexible Leiterplatte und werden auf der Rückseite der flexiblen Leiterplatte abgebogen (crimping process). Mit der plastischen Deformation der Krallen ist der Kontakt fest mit der flexiblen Leiterplatte verbunden, wobei der elektrische Übergang zwischen Leiterbahn und Kontakt gewährleistet ist. Nach dem Anbringen des Kontaktes bzw. der Kontakte an den frei beweglichen Leiterbahnenden bzw. Segmenten wird der Kontakt bzw. werden die Kontakte in ein Gehäuse gesteckt.

Aus dem Stand der Technik sind halbautomatische Einrichtungen bekannt, die die Kontakte an den Leiterbahnen anbringen und die Kontakte mit Gehäusen bestücken. Die flexiblen Leiterbahnen werden einzeln oder ab Rollen zugeführt, wobei die Segmente vorgängig geschlitzt werden. Die Segmente werden manuell aufgerichtet und dem Crimpprozess zugeführt. Nach der Bearbeitung wird das Segment ungefähr wieder in die ursprüngliche Lage gebracht.

Mit der manuellen Zuführung der Segmente ist die Produktivität der gesamten Anlage beschränkt.

Aus der Patentschrift US 4 043 017 ist eine Einrichtung gemäß dem Oberbegriff des Anspruchs 1, bekannt geworden, bei der mehrere Kabel gleichzeitig in Kontakte eingepresst werden, wobei der Mantel des Kabels vom jeweiligen Kontakt bis auf den Leiter eingeschnitten wird. Ein horizontal verschiebbarer, zweiteiliger Kabelkamm hält die Kabel nebeneinander liegend fest, wobei beim Vorschieben des Kabelkammes die Kabel mittels einer Gleitführung dem Kontaktgehäuse zugeführt werden.

Nachteilig bei dieser Einrichtung ist insbesondere die manuell bedienbare Haltevorrichtung mit dem Kabelkamm, mit der eine effiziente Verdrahtung von Kontaktgehäusen nicht machbar ist.

Hier will die Erfindung Abhilfe schaffen. Die Erfindung, wie sie in Anspruch 1 gekennzeichnet ist, löst die Aufgabe, die Nachteile der bekannten Einrichtung zu vermeiden und eine Einrichtung zu schaffen, mittels der die Bearbeitung flexibler Leiterplatten effizienter ausgeführt werden kann.

Die durch die Erfindung erreichten Vorteile sind im wesentlichen darin zu sehen, dass die Produktivität erhöht und die Qualität verbessert werden kann. Die erfindungsgemässe Vorrichtung ist oberhalb der die flexible Leiterbahn tragende und für den Transport der Leiterbahn notwendigen Unterlage angeordnet. Für die Handhabung der flexiblen Leiterplatten notwendige Durchbrüche in der Unterlage sind nicht notwendig. Mit der durchbruchfreien, glatten Unterlage können weder Kratzer noch Verletzungen an der flexiblen Leiterplatte beim Transport entstehen.

Anhand der beiliegenden Figuren wird die vorliegende Erfindung näher erläutert.

Es zeigen:
Fig. 1
   einen Ausschnitt einer flexiblen Leiterplatte mit Segmenten,
Fig. 2
   bestückte Segmente der Leiterplatte,
Fig. 3
   eine Segmentrückseite mit bestückten Kontakten,
Fig. 4
   eine Segmentleiterseite mit bestückten Kontakten,
Fig. 4a
   gegurtete Kontakte vor der Bestückung,
Fig. 5
   eine Draufsicht einer Einrichtung zur Konfektionierung einer flexiblen Leiterplatte mit Segmenten,
Fig. 6
   eine Crimppresse zur Bestückung eines Segmentes mit Kontakten,
Fig. 7
   einen Gehäusebestücker zur Bestückung der Kontakte mit einem Gehäuse und eine Haltevorrichtung zum Halten des zu bestückenden Segmentes,
Fig. 8
   eine Anordnungsvariante der Haltevorrichtung,
Fig. 9
   eine Draufsicht der Haltevorrichtung vor dem Anheben eines Segmentes und
Fig. 10
   die Haltevorrichtung beim Halten des Segmentes während des Bestückungsvorganges.

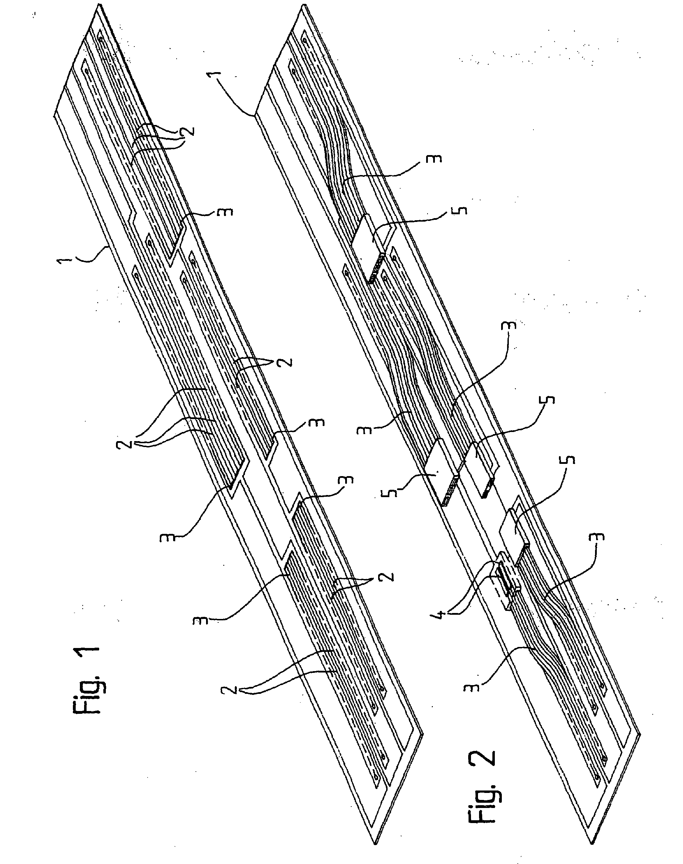

Fig. 1 zeigt einen Ausschnitt einer flexiblen Leiterplatte 1 mit elektrischen Leiterbahnen 2. Am Ende mindestens einer Leiterbahn 2 wird die flexible Leiterplatte 1 seitlich und stirnseitig der Leiterbahn 2 eingeschnitten bzw. geschlitzt. Der frei bewegliche Teil mit den Leiterbahnenden, auch Segment genannt, ist mit 3 bezeichnet.

Fig. 2 zeigt bestückte Segmente 3 der flexiblen Leiterplatte 1. An den frei beweglichen Leiterbahnenden sind elektrische Kontakte 4 mittels Crimpverfahren mit den Leiterbahnen 2 verbunden, wobei die Kontakte 4 mit Gehäusen 5 bestückt sind.

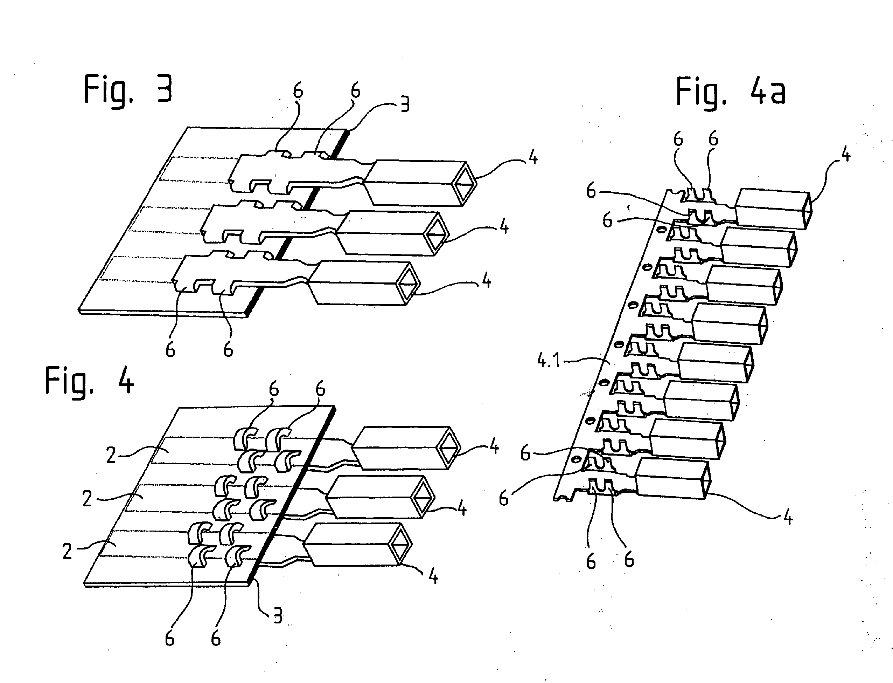

Fig. 3 zeigt eine Segmentrückseite mit bestückten Kontakten 4, wobei jeder Kontakt 4 mit Krallen 6 versehen ist. Die Krallen 6 des Kontaktes 4 durchstossen (piercing process) die flexible Leiterplatte 1 und werden wie in Fig. 4 gezeigt auf der Leiterseite der flexiblen Leiterplatte 1 abgebogen (crimping process). Die Krallen 6 durchstossen die flexible Leiterplatte 1 neben den Leiterbahnen 2 und werden auf die Leiterbahnen 2 abgebogen. Es können auch Kontakte vorgesehen sein, deren Krallen die Leiterbahnen durchstossen. Mit der plastischen Deformation der Krallen 6 ist der Kontakt 4 fest mit der flexiblen Leiterplatte 1 verbunden, wobei der elektrische Übergang zwischen Leiterbahn 2 und Kontakt 4 gewährleistet ist.

Fig. 4a zeigt Bandware bzw. gegurtete Kontakte 4 vor der Bestückung. Die gegurteten Kontakte 4 stehen für den Crimpvorgang ab Rolle zur Verfügung und werden vor dem Crimpen vom Band 4.1 getrennt.

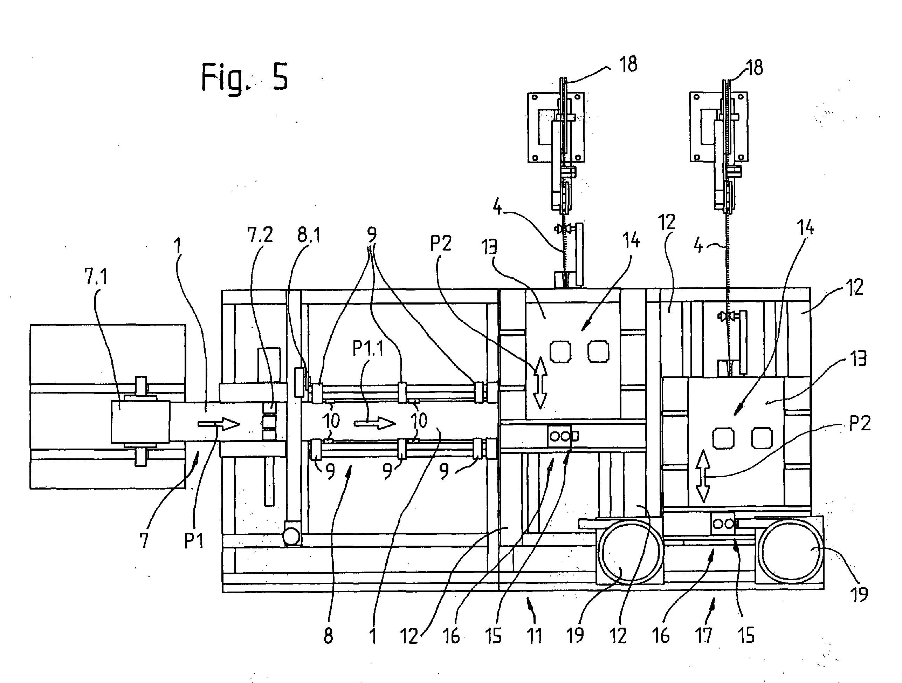

Fig. 5 zeigt eine Draufsicht einer Einrichtung zur Konfektionierung einer flexiblen Leiterplatte 1 mit Segmenten 3. Die flexible Leiterplatte 1 wird in einer Eingangsstation 7 ab Rolle 7.1 mittels Abziehrollen 7.2 in Pfeilrichtung P1 einer Abziehstation 8 zugeführt, die am Eingang eine Schneideinrichtung 8.1 aufweist. Die Schneideinrichtung 8.1 schneidet die flexible Leiterplatte 1 auf die gewünschte Länge bzw. auf den gewünschten Nutzen.

Der Nutzen wird mittels als Führung und Halter dienende Haltegreifer 9 und als Vorschub dienende Transportgreifer 10 in Pfeilrichtung P1.1 zu einer ersten Bearbeitungsstation 11 transportiert. Wie in Fig. 5 gezeigt sind auf beiden Seiten des zu transportierenden Nutzen Haltegreifer 9 und Transportgreifer 10 angeordnet. Haltegreifer 9 und Transportgreifer 10 können auch nur auf einer Seite des Nutzen angeordnet sein. In der ersten Bearbeitungsstation 11 werden die Segmente 3 aufgerichtet und mit Kontakten 4 versehen, die je Segment 3 in Gehäuse 5 gesteckt werden. An einer entlang von ersten Linearachsen 12 in Pfeilrichtung P2 bewegbaren ersten Plattform 13 sind eine Crimppresse 14 und ein Gehäusebestücker 15 angeordnet. Nicht dargestellt ist der Antrieb für die erste Plattform 13. Eine unterhalb der ersten Plattform 13 angeordnete Haltevorrichtung 16 richtet die Segmente 3 von der flexiblen Leiterplatte 1 auf, hält die Segmente 3 während der Bearbeitung fest und bringt die Segmente 3 danach wieder in die Ausgangslage. Die Crimppresse 14 wird mit Kontakten 4 versorgt, die gegurtet ab Rolle 18 zur Verfügung stehen. Ein Gehäusebunker 19 hält die Gehäuse 5 für den Gehäusebestücker 15 bereit.

In einer weiteren Bearbeitungsstation 17 werden Segmente 3 mit zu den Kontakten 4 der ersten Bearbeitungsstation 11 unterschiedlichen Kontakten bestückt. Je Kontaktart oder Orientierung des zu bestückenden Segmentes ist eine weitere Bearbeitungsstation vorgesehen, wobei die Bearbeitungsstationen im Aufbau vergleichbar sind. Der Gehäusebestücker 15 der weiteren Bearbeitungsstation 17 ist gerade dabei, vom Gehäusebunker 19 Gehäuse 5 aufzunehmen. Nach der letzten Bearbeitungsstation ist eine Ausgangsstation vorgesehen, die die konfektionierten Nutzen stapelt und ausgibt.

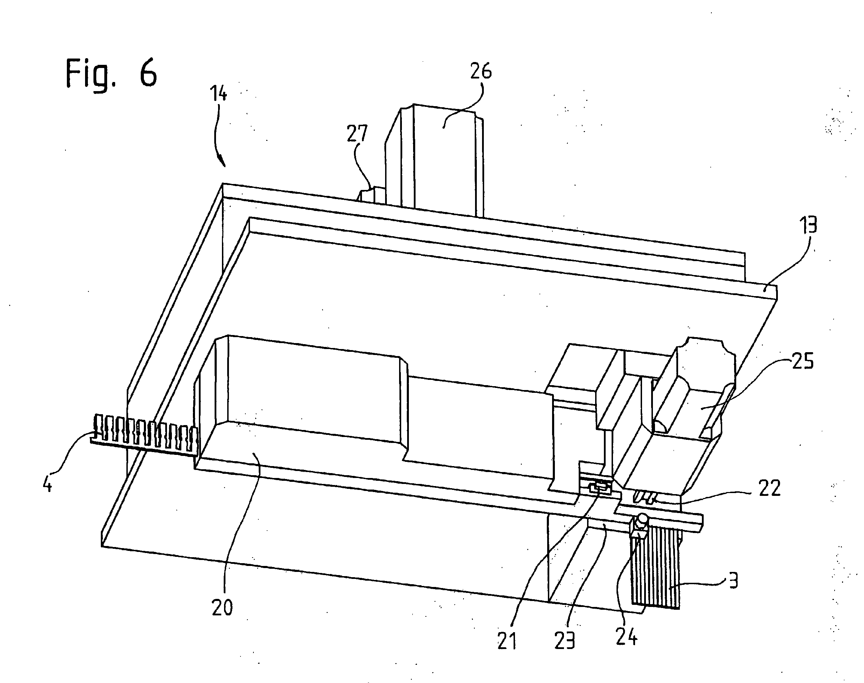

Fig. 6 zeigt schematisch die Crimppresse 14 zur Bestückung eines Segmentes 3 mit Kontakten 4. Die Kontakte 4 werden gegurtet einem ersten Vorschub 20 zugeführt, der die Kontakte 4 mittels eines Messers 21 trennt. Ein oberer Crimpstempel 22 nimmt die Kontakte 4 einzeln auf und bestückt das mittels der Haltevorrichtung 16 gehaltene Segment 3, wobei die Krallen 6 das Segment 3 durchstossen und mittels eines unteren Crimpstempels 23 wie in Fig. 4 gezeigt auf die Leiterbahn 2 abgebogen werden. Vor der Bestückung ist die erste Plattform 13 mittels eines die Kante des Segmentes 3 abtastenden ersten Detektors auf das Segment 3 positioniert worden. Ein zweiter Detektor 24 tastet mindestens die erste Leiterbahn 4 des Segmentes 3 ab und positioniert den oberen Crimpstempel 22 und den unteren Crimpstempel 23 auf die zu bestückende Leiterbahn 2. Ein erster Antrieb 25 ist für die Bewegung des oberen Crimpstempels 22 vorgesehen. Ein zweiter Antrieb 26 positioniert den oberen Crimpstempel 22 und ein dritter Antrieb 27 positioniert den unteren Crimpstempel 23 auf die zu bestückende Leiterbahn 2.

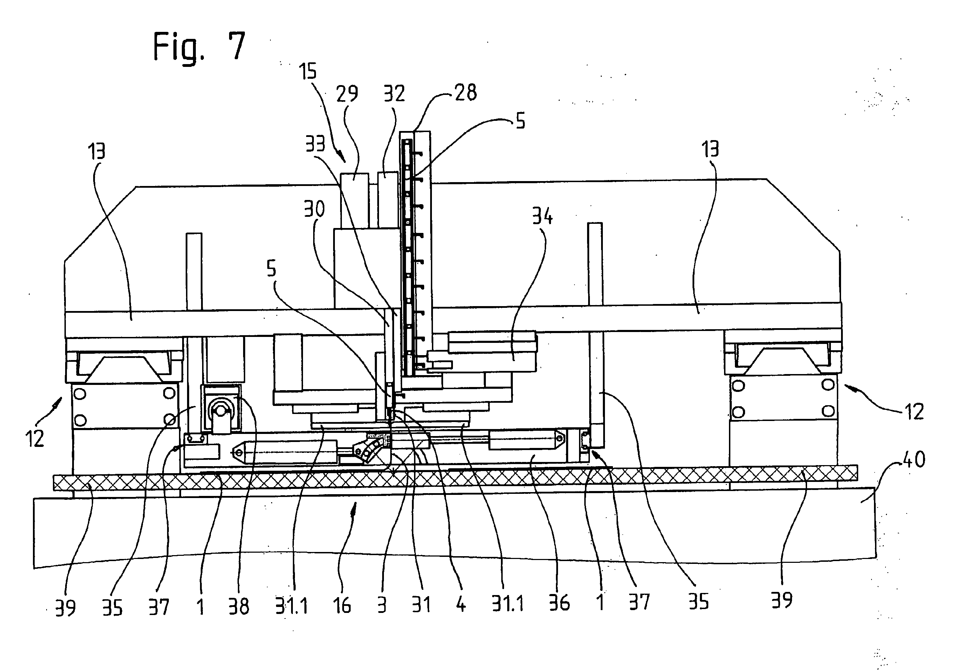

Fig. 7 zeigt den Gehäusebestücker 15 zur Bestückung mindestens eines Kontaktes 4 mit einem Gehäuse 5 und die Haltevorrichtung 16 zum Halten des zu bestückenden Segmentes 3. Der Gehäusebestücker 15 ist an der ersten Plattform 13 angeordnet, die entlang der ersten Linearachsen 12 quer zur Transportrichtung der flexiblen Leiterplatte 1 bewegbar ist. Die Linearachsen 40 sind auf einer festen Stütze 40 abgestützt und mindestens eine Linearachse 12 ist mit einem nicht dargestellten Linearantrieb versehen. Die Gehäuse 5 sind in einem ersten Gehäuseschacht 28 auf Vorrat, wobei die Gehäuse 5 vom Gehäusebunker 19 nachgeliefert werden. Die am aufgerichteten Segment 3 angeordneten Kontakte 4 werden mittels eines Positionierbleches 31.1 ausgerichtet und gehalten, wobei ein zustellbarer zweiseitiger Kamm die Kontakte umfasst. Ein mittels erstem Zylinder 29 angetriebener erster Stössel 30 schiebt das in einem zweiten Gehäuseschacht 31 lagernde Gehäuse 5 über die Kontakte des mittels der Haltevorrichtung 16 gehaltenen Segmentes 3. Danach verschliesst ein mittels zweitem Zylinder 32 angetriebener zweiter Stössel 33 das Gehäuse 5. Nach dem Rückzug der Stössel 30,33 ist der zweite Gehäuseschacht 31 frei zur Aufnahme eines weiteren Gehäuses 5, das mittels eines zweiten Vorschubes 34 in den Gehäuseschacht 31 transportiert wird.

An der ersten Plattform 13 sind Träger 35 angeordnet, die eine zweite Plattform 36 tragen. Die Plattform 36 ist entlang von zweiten Linearachsen 37 verschiebbar gelagert, wobei ein zweiter Linearantrieb 38 die zweite Plattform 36 bewegt. Die quer zur Transportrichtung der flexiblen Leiterplatte 1 bewegbare zweite Plattform 36 dient als Träger für die Haltevorrichtung 16, die oberhalb einer die flexible Leiterplatte 1 tragenden Unterlage 39 angeordnet ist. Während des Bestückungsvorganges führt die zweite Plattform 36 eine Gegenbewegung zur Bewegung der ersten Plattform 13 aus, wobei die Haltevorrichtung 16 gegenüber der flexiblen Leiterplatte 1 stationär bleibt. Bewegt sich die erste Plattform 13 zum Anfahren der Crimppresse 14 oder des Gehäusebestückers 15 an das zu bestückende Segment 3 bleibt die Haltevorrichtung 16 ortsfest.

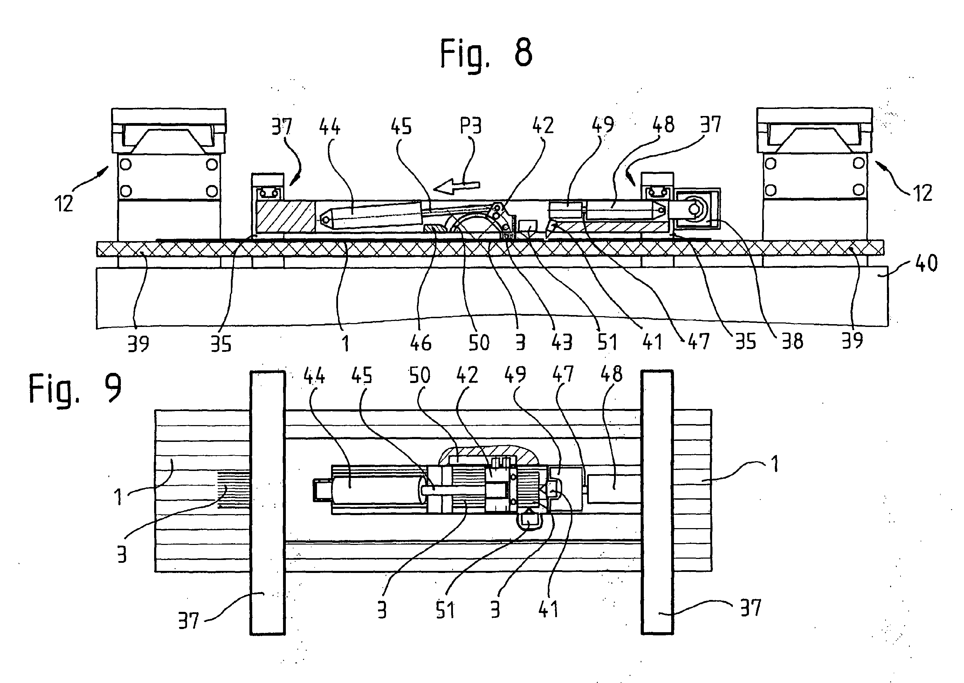

Die Fig. 8, 9 und 10 zeigen eine Anordnungsvariante der Haltevorrichtung 16. Die zweite Plattform 36 ist nicht wie oben gezeigt mit der ersten Plattform 13 verbunden. Die Träger 35 der zweiten Plattform 36 sind auf der festen Stütze 40 abgestützt. Die zweite Plattform 36 mit der Haltevorrichtung 16 wird auf das zu bestückende Segment 3 positioniert und bleibt dann während des Bestückungsvorganges ortsfest.

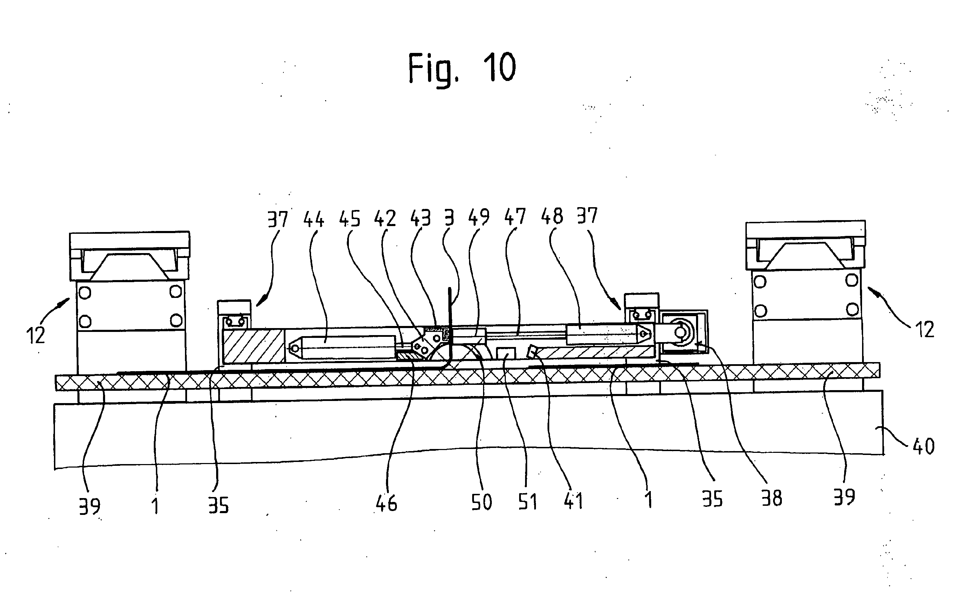

Fig. 8 und Fig. 9 zeigen die Haltevorrichtung 16 vor dem Anheben eines Segmentes 3. Ein dritter Detektor 41 tastet die Stirnkante des Segmentes 3 ab und stoppt den Vorschub der flexiblen Leiterplatte 1. Ein vierter Detektor 51 tastet die Seitenkante des Segmentes 3 ab und positioniert die Haltevorrichtung 16 in Querrichtung zur flexiblen Leiterplatte 1 auf das zu bestückende Segment 3. Ein an einem Schlitten 42 angeordneter Vakuumgreifer 43 fasst das Segment 3 indem der Vakuumgreifer 43 auf Vakuum geschaltet wird. Ein dritter Zylinder 44 führt mit seiner Kolbenstange 45 eine Bewegung bis zu einem Anschlag 46 in Pfeilrichtung P3 aus und dreht dabei den Schlitten 42 entlang einer kreisrunden Führung 50 um 90°, wobei das Segment 3 aufgerichtet wird. Dann wird eine Kolbenstange 47 eines vierten Zylinders 48 ausgefahren, wobei die Kolbenstange 47 einen Stempel 49 auf der Rückseite des Segmentes 3 gegen den Vakuumgreifer 43 presst. Das Segment 3 wird nun wie in Fig. 10 gezeigt festgehalten zwischen Vakuumgreifer 43 und Stempel 49 bis der Bestückungsvorgang abgeschlossen ist. Danach wird der Stempel 49 zurückgezogen, der Schlitten 42 mittels des dritten Zylinders 44 um 90° zurückgedreht und der Vakuumgreifer 43 gelöst indem der Vakuumgreifer 43 auf Druck geschaltet wird. Das bestückte Segment 3 ist dann erneut in der ungefähren Ausgangslage.

Mit der in den Fig. 7 bis 10 gezeigten Orientierung der Haltevorrichtung 16 können die beiden linken Segmente 3 der in Fig. 1 gezeigten Leiterplatte 1 aufgerichtet werden. Die Aufrichtung erfolgt im Gegenuhrzeigersinn. Die übrigen Segmente 3 der in Fig. 1 gezeigten Leiterplatte 1 müssen im Uhrzeigersinn aufgerichtet werden. Dazu wird die Haltevorrichtung 16 in der jeweiligen Bearbeitungsstation so orientiert, dass der Schlitten 42 eine Bewegung im Uhrzeigersinn ausführt.

Die oben dargelegte Bearbeitung der Segmente 3 umfasst die Bestückung der Segmente 3 mit Kontakten 4 und die Bestückung der Kontakte 4 mit Gehäusen 5. Die Haltevorrichtung 16 zum Aufrichten der Segmente 3 kann auch für andere Bearbeitungen verwendet werden wie beispielsweise Reinigen der Leiterbahnen, Vorbereiten der Leiterbahnen für den Lötvorgang, Herstellen von Lötverbindungen oder Anbringen von Bohrungen oder Stanzungen an den Segmenten 3 und/oder an den Leiterbahnen 2 der Segmente 3.

## Patentansprüche

1. Einrichtung zur Konfektionierung einer flexiblen Leiterplatte (1) mit mindestens einem mindestens ein Leiterende umfassenden Segment (3), wobei das Segment (3) Teil der flexiblen Leiterplatte (1) ist und zur Bearbeitung aufrichtbar ist,
dass eine Haltevorrichtung (16) zur Handhabung des Segmentes (3) vorgesehen ist, die das Segment (3) von der flexiblen Leiterplatte (1) aufrichtet, zur Bearbeitung festhält und nach der Bearbeitung in die ungefähre Ausgangslage bringt, **dadurch gekennzeichnet daß** die Haltevorrichtung (16) oberhalb einer die flexible Leiterplatte (1) tragende und für den Transport der Leiterplatte notwendige Unterlage (39) angeordnet ist und zum Fassen des Segmentes (3) einen Vakuumgreifer (43) aufweist, der zum Aufrichten des Segmentes (3) drehbar ist, wobei nach dem Aufrichten ein Stempel (49) das Segment (3) gegen den Vakuumgreifer (43) presst.

2. Einrichtung nach Anspruch 1,
**dadurch gekennzeichnet,**
**dass** die Haltevorrichtung (16) an einer zweiten Plattform (36) angeordnet ist, die quer zur Transportrichtung der flexiblen Leiterplatte (1) bewegbar ist.

3. Einrichtung nach Anspruch 2,
**dadurch gekennzeichnet,**
**dass** die zweite Plattform (36) entlang von zweiten Linearachsen (37) bewegbar ist, die an einer quer zur Transportrichtung der flexiblen Leiterplatte (1) bewegbaren ersten Plattform (13) angeordnet sind.

4. Einrichtung nach Anspruch 2,
**dadurch gekennzeichnet,**
**dass** die zweite Plattform (36) entlang von zweiten Linearachsen (37) bewegbar ist, die an einer festen Stütze (40) angeordnet sind.

5. Einrichtung nach einem der Ansprüche 1 bis 4,
**dadurch gekennzeichnet,**
**dass** an der zweiten Plattform (36) Detektoren (41,51) angeordnet sind, die die Kanten des Segmentes (3) erfassen und die Haltevorrichtung (16) auf das Segment (3) positionieren.

6. Einrichtung nach einem der Ansprüche 1 bis 5,
**dadurch gekennzeichnet,**
**dass** der Vakuumgreifer (43) und der Stempel (49) mittels Zylinder (44,48) bewegbar sind und der Vakuumgreifer (43) in einer kreisförmigen Führung (50) geführt ist.

7. Einrichtung nach einem der Ansprüche 1 bis 6
**dadurch gekennzeichnet,**
**dass** mindestens eine Bearbeitungsstation (11,17) oberhalb einer die flexible Leiterplatte (1) tragende und für den Transport der Leiterplatte (1) notwendige Unterlage (39) angeordnet ist und die Bearbeitungsstation (11,17) zur Bearbeitung mindestens eines mittels der Haltevorrichtung (16) aufrichtbaren und während der Bearbeitung haltbaren Segmentes (3) in mindestens einem Arbeitsgang vorgesehen ist.

8. Einrichtung nach Anspruch 7,
**dadurch gekennzeichnet,**
**dass** die Bearbeitungsstation eine Crimppresse (14) zum Bestücken mindestens eines Segmentes (3) mit mindestens einem Kontakt (4) und einen Gehäusebestücker (15) zum Bestücken mindestens eines Kontaktes (4) mit einem Gehäuse (5) aufweist.

9. Einrichtung nach einem der Ansprüche 7 oder 8,
**dadurch gekennzeichnet,**
**dass** die Crimppresse (14) und der Gehäusebestücker (15) quer zur Transportrichtung der flexiblen Leiterplatte (1) bewegbar sind und die Haltevorrichtung (16) gegenüber der Crimppresse (14) und dem Gehäusebestücker (15) quer zur Transportrichtung der flexiblen Leiterplatte (1) bewegbar ist.

## Claims

1. Equipment for fitting out a flexible printed circuit (1) having at least one segment (3) comprising at least one conductor end, wherein the segment (3) is part of a flexible printed circuit (1) and can be raised up for the processing, that for handling of the segment (3) there is provided a holding device (16) which raises the segment (3) up from the flexible printed circuit (1), firmly holds the segment for processing and brings the segment into the approximate starting position after the processing, **characterised in that** the holding device (16) is arranged above a support (39), which carries the flexible printed circuit (1) and is required for transport of the printed circuit, and for gripping of the segment (3) comprises a vacuum gripper (43) which is rotatable for raising up the segment (3), wherein after the raising-up a die (49) presses the segment (3) against the vacuum gripper (43)..

2. Equipment according to claim 1, **characterised in that** the holding device (16) is arranged at a second platform (36), which is movable transversely relative to the transport direction of the flexible printed circuit (1).

3. Equipment according to claim 2, **characterised in that** the second platform (36) is movable along second linear axles (37), which are arranged at a first platform (13) movable transversely to the transport direction of the flexible printed circuit (1).

4. Equipment according to claim 2, **characterised in that** the second platform (36) is movable along second linear axles (37) which are arranged at a fixed support (40).

5. Equipment according to one of claims 1 to 4, **characterised in that** arranged at the second platform (36) are detectors (41, 45) which detect the edges of the segment (3) and position the holding device (16) on the segment (3).

6. Equipment according to one of claims 1 to 5, **characterised in that** the vacuum gripper (43) and the die (49) are movable by means of cylinders (44, 48) and the vacuum gripper (43) is guided in a circular guide (50).

7. Equipment according to one of the claims 1 to 6, **characterised in that** at least one processing station (11, 17) is arranged above a support (39) carrying the flexible printing circuit (1) and necessary for transport of the printed circuit (1), and the processing station (11, 17) is provided for processing at least one segment (3), which can be raised by means of the holding device (16) and held during the processing in at least one working step.

8. Equipment according to claim 7, **characterised in that** the processing station comprises a crimping press (14) for equipping at least one segment (3) with at least one contact (4) and a housing equipping means (15) for fitting at least one contact (4) with a housing (5).

9. Equipment according to one of claims 7 or 8, **characterised in that** the crimping press (14) and the housing equipping means (15) are movable transversely to the transport direction of the flexible printed circuit (1) and the holding device (16) is movable relative to the crimping press (14) and the housing equipping means (15) is movable transversely to the transport direction of the flexible printed circuit (1).the transport direction of the flexible printed circuit (1).

## Revendications

1. Dispositif pour fabriquer une plaquette imprimée flexible (1) avec au moins un segment (3) comportant au moins une extrémité de conducteur, le segment (3) faisant partie de la plaquette imprimée flexible (1) et pouvant être relevé pour le traitement,
dans lequel il est prévu un dispositif de fixation (16) pour la manipulation du segment (3), qui relève celui-ci à partir de la plaquette flexible (1), qui l'immobilise pour le traitement et qui le ramène dans sa position initiale approximative, après le traitement,
**caractérisé en ce que** le dispositif de fixation (16) est disposé au-dessus d'un support (19) qui porte la plaquette imprimée flexible (1) et qui est nécessaire au transport de celle-ci, et comporte pour saisir le segment (3) un organe de préhension à vide (43) qui est apte à tourner pour relever le segment (3), un poinçon (49) poussant le segment (3) contre l'organe de préhension (43) après le relèvement.

2. Dispositif selon la revendication 1, **caractérisé en ce que** le dispositif de fixation (16) est disposé sur une seconde plate-forme (36) qui est mobile transversalement par rapport au sens de transport de la plaquette imprimée flexible (1).

3. Dispositif selon la revendication 2, **caractérisé en ce que** la seconde plate-forme (36) est mobile le long de seconds axes linéaires (37) qui sont disposés sur une première plate-forme (13) mobile transversalement par rapport au sens de transport de la plaquette imprimée flexible (1).

4. Dispositif selon la revendication 2, **caractérisé en ce que** la seconde plate-forme (36) est mobile le long de seconds axes linéaires (37) qui sont disposés sur un support fixe (40).

5. Dispositif selon l'une des revendications 1 à 4,
**caractérisé en ce qu'**il est prévu sur la seconde plate-forme (36) des détecteurs (41, 51) qui détectent les bords du segment (3) et qui positionnent le dispositif de fixation (16) sur le segment (3).

6. Dispositif selon l'une des revendications 1 à 5, **caractérisé en ce que** l'organe de préhension à vide (43) et le poinçon (49) sont mobiles grâce à des cylindres (44, 48) et l'organe de préhension à vide (43) est guidé dans un guide circulaire (50).

7. Dispositif selon l'une des revendications 1 à 6, **caractérisé en ce qu'**au moins une station de traitement (11, 17) est disposée au-dessus d'un support (39) qui porte la plaquette imprimée flexible (1) et qui est nécessaire au transport de celle-ci, et la station de traitement (11, 17) est prévue pour traiter en au moins une opération au moins un segment (3) apte à être relevé à l'aide du dispositif de fixation (16) et à être immobilisé pendant le traitement.

8. Dispositif selon la revendication 7, **caractérisé en ce que** la station de traitement comporte une presse de sertissage (14) pour garnir au moins un segment (3) avec au moins un contact (4), et un dispositif de pose de boîtiers (15) pour garnir au moins un contact (4) avec un boîtier (5).

9. Dispositif selon la revendication 7 ou 8, **caractérisé en ce que** la presse de sertissage (14) et le dispositif de pose de boîtiers (15) sont mobiles transversalement par rapport au sens de transport de la plaquette imprimée flexible (1) et le dispositif de fixation (16) est mobile par rapport à la presse de sertissage (14) et au dispositif de pose de boîtiers (15) transversalement par rapport au sens de transport de la plaquette (1).
